# EUROPEAN PATENT SPECIFICATION

(11) **EP 3 782 258 B1**
(45) Date of publication and mention of the grant of the patent: **22.04.2026**
(21) Application number: 19717981.5
(22) Date of filing: 11.04.2019
(51) Int. Cl.: H10N 30/30, H10N 30/85, H02J 7/02, H02N 2/18

(54) **ENERGY CONVERSION DEVICE AND PRODUCTION METHOD**
ENERGIEUMWANDLUNGSVORRICHTUNG UND HERSTELLUNGSVERFAHREN
DISPOSITIF DE CONVERSION D'ÉNERGIE ET PROCÉDÉ DE FABRICATION

(30) Priority: 16.04.2018 IT 201800004538
(43) Date of publication of application: 24.02.2021
(73) Proprietor: Consiglio Nazionale Delle Ricerche, 00185 Roma (IT); Agenzia Nazionale Per Le Nuove Tecnologie, L'Energia E Lo Sviluppo Economico Sostenibile (ENEA), 00196 Roma (IT); Université Grenoble Alpes, 38400 Saint Martin d'Hères (FR)
(72) Inventor: CASTAGNA, Riccardo, 00185 Roma (IT); RIPPA, Massimo, 00185 Roma (IT); PETTI, Lucia, 00185 Roma (IT); DE GIROLAMO DEL MAURO, Anna, 00196 Roma (IT); NENNA, Giuseppe, 00196 Roma (IT); DILETTO, Claudia, 00196 Roma (IT); ARDILA RODRIGUEZ, Gustavo, 38400 Saint-Martin-d'Hères (FR)
(74) Representative: Santi, Filippo
(86) International application number: PCT/IT2019/050074
(87) International publication number: WO 2019/202620

(56) References cited:
- US-B1- 8 525 393

## Description

### Technical field of the invention

The present invention relates to a energy conversion device, in particular a device configured to be exposed to an incident light beam, which allows the conversion of a light pulse into an electrical signal.

### Background

Devices for converting solar energy into electrical energy are known.

In particular, this conversion is made by solar cells which, through the photovoltaic effect, converts the energy of the incident light into electricity.

As is well known, solar or photovoltaic cells require the use of semiconductor materials, in particular silicon, which must be used in their pure crystalline form and which therefore involve particularly expensive embodiments.

Recently, the research to improve the performance of these conversion systems is dedicated to obtain optimized incident light concentration systems, at low cost.

In particular, the use of more and more sophisticated optics has given rise to various types of systems for solar power plants (Concentrating Solar Power, CSP).

The optimization of the systems for light beam concentration, although necessary to maximize conversion efficiency, does not solve the problems related to the production and the hight costs of photovoltaic cells.

Moreover, in the sector of the use of alternative energy sources, devices are known for exploiting the kinetic energy supplied by water or wind. In particular, piezoelectric crystals or polymeric materials are used which, under mechanical deformation, generate an electrical potential.

These devices have some drawbacks which make their actual use difficult.

In particular, the direct exposure of piezoelectric crystals or polymeric materials to the wheater agents can cause structural damage which can cause a rapid loss of efficiency in the energy conversion process.

US 8 525 393 B1 describes an energy conversion micro electromechanical system (MEMS) to convert the radiant energy received from the sun, or other light source, into heat which is used to produce electricity, using the effect piezoelectric, through a first transformation of radiant energy into thermal energy.

### Summary of the invention

Therefore, the technical problem placed and solved by the present invention is that to provide an energy conversion device, which allows to overcome the drawbacks mentioned above with reference to the prior art.

This problem is solved by a conversion device according to claim 1 and by a method according to claim 8.

Preferred features of the present invention are subject of the depending claims.

The device according to the present invention has a high number of advantages compared to conventional solutions.

Advantageously, the device of the present invention increases the energy efficiency as it optimizes the usability of alternative energy sources.

In particular, the characteristic to have an actuator element comprising a surface portion made of a photomobile polymeric material, allows to make the device sensitive to a luminous signal.

Advantageously, the presence of a semi-rigid elastic portion allows an exploitation of alternative kinetic energy sources, such as for example water or wind, ensuring the usability of the conversion device even in the absence of a light signal.

A further advantage of the device according to the present invention is the sustainability both in terms of easy availability of materials and from an economic point of view.

Moreover, the possibility to use solar energy conversion plants, compared to wind or photovoltaic turbines, allows an easy implementation with energy storage systems obtained from an electrical storage device, and therefore the generation of conveyable energy.

Other advantages, features and methods of use of the present invention will be evident from the following detailed description of some embodiments, presented by way of a non-limiting example.

### Brief description of the figures.

Reference will be made to the figures of the attached drawings, wherein:
Figure 1a shows a schematic view of a realization step of a transducer element of an embodiment of the device according to the present invention;
Figure 1b shows a schematic view of a further realization step of the element of Figure 1a;
Figure 2 shows a schematic sectioned view of a production step of a preferred embodiment of the device according to the present invention;
Figure 3 shows a schematic view of the embodiment of the actuator device of Figure 2;
Figures 4a and 4b show images obtained by means of the scanning electron microscope (SEM) related to a production step of the device of Figure 3;
Figure 5 shows a top view of a prototype of the device of Figure 3;
Figures 6a-6c show schematic views of an operating sequence of an embodiment of the device according to the present invention;
Figures 7a-7d show schematic views of an operating sequence of a further embodiment of the device according to the present invention.

In the various figures the similar parts will be indicated with the same numerical references.

### Detailed description of the preferred embodiments.

With reference to the figures mentioned above, a converting device according to a preferred embodiment of the invention is designated as a whole with 100.

The energy conversion device 100, configured to convert a light signal into an electrical signal, comprises a substantially planar actuator element 50 which has at least an activable portion 30. The activable portion, as will be better described below, comprises a photomobile polymeric material.

The device 100 further comprises a transducer element 60, substantially planar, having at least a portion of piezoelectric material.

Advantageously, the actuator element 50 and the transducer element 60 are coupled each other, in particular at an interface surface, so that, at a light beam incident on said photomobile polymeric material, a movement of the transducer element 60 is actuated, by a movement of the activable portion 30.

Consequently, the movement of the transducer element 60 produces the generation of an electric potential difference at the terminal ends of the piezoelectric material portion.

In particular, the activable portion 30, preferably semi-rigid, is substantially elastic and is configured to be moved from a substantially planar configuration to a substantially bent operating configuration at an incident light beam.

The known photomobile polymers are based on liquid-crystalline azobenzenes or, more recently developed, on bilayers of polycarbonates / PDMS and graphene / nanotube oxides.

The limiting factor for the large scale use of this type of photomobile polymers is the cost associated with them.

For example, a synthesis method of photomotive polymers based on liquid-crystalline azobenzenes, requires many steps and therefore takes rather long times to synthesise a few milligrams of monomer with related high costs.

Therefore, the invention according to the present invention comprises a photomobile polymeric material, which is easier to produce and is obtained from materials that are easy to find and to synthesize.

Preferably, the photomobile polymeric material is obtained from multi-acrylates and phenol oxides in vinyl matrices.

In particular, the photomobile polymeric material here described comprises two portions.

A first portion so called "skeleton", has a higher degree of polymerization and a semi-rigid elastic configuration, acts as an activable portion 30.

A second portion, so called "engine", has a lower degree of polymerization and increases its temperature at an incident light beam.

In particular, the difference in structural terms between the first and second portion causes a different thermal expansion between the two portions, resulting in a deflection of the actuator element at a conversion of photonic energy into mechanical work made by the photomobile polymer material exposed at an incident light beam.

The description below will be directed to a light-controlled conversion device but it is very evident that the same should not be considered limited to this specific use, since the activable portion 30 of the photomobile polymer can also be activated by wind or other weather agents.

Preferably, as anticipated, the photomobile polymeric component is obtained by the use of multi-acrylates and phenol oxides in vinyl matrices (as described for example in R. Castagna, et al., "An unconventional approach to photomobile composite polymer films", Adv. 2017, 29, 1604800).

In particular, in the present example a multi-acrylate, 4-amino-phenol and oxidized NVP are used, as will be better described below.

Advantageously, the material is obtained by a low-cost asymmetric photo-polymerization.

Moreover, the presence of the multi-acrylate allows to pattern the photopolymer film (PMP) obtaining metallic patterns grafted onto the surfaces of mobile devices whose movement is induced and controlled by a plasmonic field.

In fact, for example, by extracting gold from plasmonic substrates of prefabricated nanopillars on rigid conductive glass substrates (ITO-glass), it is possible to realize substrates based on gold nano-baskets nestled in the PMP matrix.

Advantageously, the possibility to realize plasmonic patterns on a PMP photopolymer support allows to control the wavelength of the absorbance peak (plasmonic resonance) to which the polymer is to be moved.

This fact makes it possible to realize - in principle - photomobile polymers that can be used at all wavelengths of the UV - Vis - NIR spectrum, greatly increasing the sensitivity of the system to the solar spectrum.

As anticipated, the photomobile polymeric material (PMP) of the present example comprises:
a) an activable portion 30, shaped as a semi-rigid skeleton, for example having a thickness of about 5-10 µm, having a certain degree of elasticity which tends to return the element to an initial rest configuration, after a deformation. In particular, the activable portion 30 here described comprises a multi-acrylate component (in particular, di-penta-erythritol-penta / hexaacrylate, DPEPA); and
b) a matrix (so called "engine"), comprising an oxidized form of 4-amino-phenol and oligo-polyvinylpyrrolidone (PVP) / N-vinyl-pyrrolidone (NVP).

At an UV-Vis irradiation of the photopolymer surface, an "engine" portion, be subject to the light beam, tends to move away from the light beam driven by a surface tension gradient generated by the light, or by the so called Marangoni effect induced by light. The Marangoni tension is the basis of mass transport at the interface between two fluids.

In general, a mass transport is achieved when a tension gradient can be generated, for example by lowering the tension in the vicinity of the object to be moved.

In the photomobile polymeric material here described, the tension is lowered at the portion where the material of the "engine" is illuminated, so at portion subjected to the light beam.

This causes a mass transport to be generated in directions distant from the illuminated portion, and then towards other portions at which an interfacial tension value is higher.

However, the moving part remains close to the most superficial layer of the photopolymer, being substantially composed of material similar to it, and tends to restore the equilibrium by capillarity and to restore the initial configuration of the photomobile film also thanks to the action of the skeleton (as described in the work of R. Castagna et al., Adv. Mat. 2017, mentioned above).

As anticipated, the film of photomobile polymeric material (PMP) of the described example is obtained by means of "asymmetric" photo-polymerization.

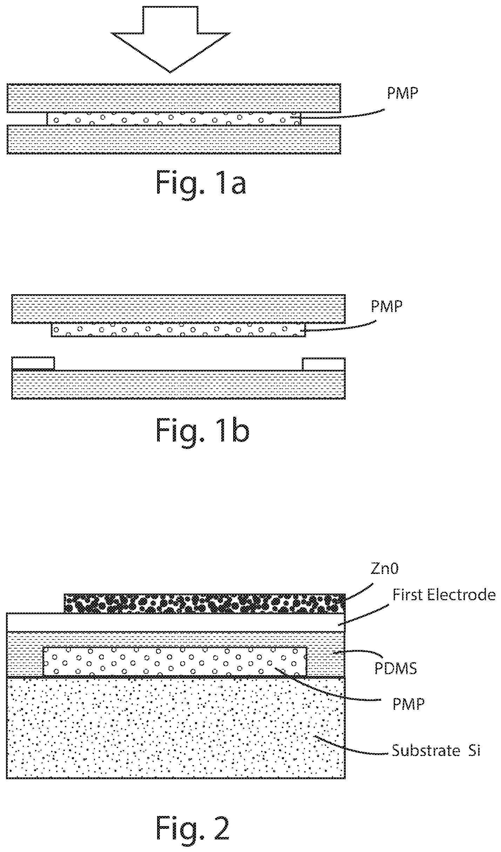

In particular, the mixture containing the starting monomers is placed between two slides maintained separated by two spacer elements - for example made of PET - positioned at the outer edges of the slides, as shown in Figure 1a and Figure 1b.

The sample is placed under UV-A irradiation, for a time of about 30 minutes.

The slides are then separated to allow further oxidation of the film in an aerobic environment, in particular for a time of about 96 hours.

The photopolymeric film thus obtained is removed from the glass substrate, for example by the use of a simple cutter, as shown in Figure 1b.

Advantageously, a superficial portion which is subjected to irradiation and to subsequent aerobic oxidation has a higher degree of polymerization with respect to a lower portion, thus giving rise to a photomobile polymeric material comprising two portions.

As anticipated above, the two portions have a different structural responce: a first semi-rigid and a second sensitive to the incidence of a light beam.

Once the photopolymer substrate has been made, in particular comprising the activable semi-rigid portion 30, the production method according to the present invention comprises a deposition step of a piezoelectric material layer (PZL) integrated on said photo-mobile portion (PMP).

To prevent structural damages of the photopolymer film, and at the same time to increase the resistance to aqueous / solvent solutions and / or the thermal resistance, a photopolymer isolation step is provided.

In particular, in the described example, being a water-soluble photopolymer film, a so called waterproofing step is provided.

The waterproofing process of the photopolymer film here described comprises a first step of deposition of a layer of polydimethylsiloxane (PDMS) in liquid form at the activable portion 30 of the photomobile polymer.

In particular, a layer having a thickness of about 3-4 µm is deposited, which represents a thickness sufficient to maintain the operative conditions (bending / relaxation) of the photopolymeric film and, at the same time, to guarantee its waterproofing.

Preferably, before to proceed with the deposition step of the waterproofing layer, the photopolymer is placed on a support to make easier the deposition step.

In particular, the support is a silicon wafer.

Advantageously, thanks to the wettability characteristics of the silicon with respect to the liquid PDMS, a reduced thickness of the PDMS layer is guaranteed.

The PDMS deposition on a support material different from the silicon would not allow to control the reduced thickness of PDMS.

In particular, the less polymerized portion of the photomobile polymer (containing oligomers of PVP) is placed in contact with the silicon support. In fact, the most sensitive part of the film, or the part configured to be dissolved by the liquid PDMS, is the less polymerized part.

The deposited PDMS layer is allowed to solidify on the photopolymer film, in particular at a temperature value lower than, or equal to, about 40-45 ° C.

In fact, higher temperature values could damage the photopolymer film here described.

In general, the waterproofing step is required for photomobile polymeric materials having solubility characteristics, for example systems based on crystalline liquid azobenzenes.

In the case of photomobile polymeric materials comprising a PDMS / polycarbonate base, the waterproofing step may not be required.

As shown in Figure 2, in the example described, once the semirigid surface of the photopolymer is waterproofed, a layer of conductive material, preferably metallic, is deposited to form a first electrode.

The conductive material for the realization of the first electrode, as well as that for the realization of the second electrode which will be described below, is selected between materials having a desired value of "work function", for example gold, silver paste, silver, platinum, etc.

Preferably, the thickness of the metal layer used for the first electrode, in particular Au, is about 60 nm.

The piezoelectric construction is then provided by the deposition of a layer of piezoelectric material on the first previously realized electrode.

In particular, a metal oxide film, for example ZnO, is deposited on the first electrode.

The use of zinc oxide does not exclude a possible use of alternative materials having piezoelectric characteristics, for example AIO aluminum oxides, AlCu copper oxides or TiO₂ titanium oxides.

A further layer of conductive material is then deposited on the piezoelectric material layer, as described above, to made the second electrode and to complete the realization of the transducer element shaped to transform mechanical energy into an electrical signal.

Advantageously, to amplify the transformation efficiency of the piezoelectric material, a piezoelectric portion is nanostructured.

In particular, nanowires of metal oxides are provided.

Advantageously, the nanowires allow to increase the efficient surface, with respect to a same considered surface, and guarantee a certain flexibility of the system, increasing the performance of the device.

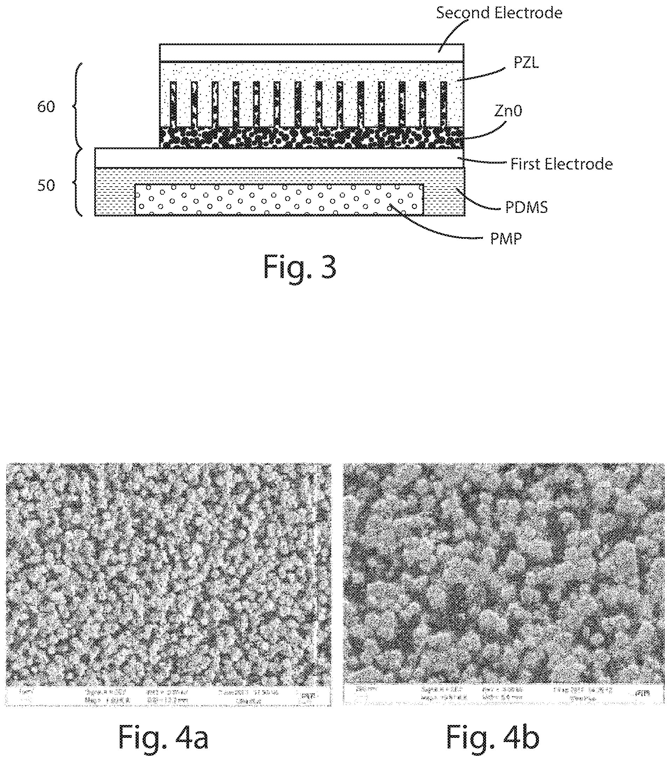

Preferably, the nanowires are made of the same material as the piezoelectric layer. Therefore, as shown in Figure 3, in the present example a growth step of ZnO nanowires on the ZnO layer is provided.

Advantageously, the provided waterproofing allows to mantain the system components intact during the growth of the ZnO nanowires.

Preferably, the growth step of the ZnO nanowires on the ZnO substrate previously made on waterproofed PMP is carried out by the Chemical Bath Deposition technique.

In particular, a growth solution is used which includes zinc nitrate hexahydrate and hexamethylene tetramine (HMTA) in a 1:1 ratio.

In the example described, the growth temperature is maintained at 85 °C for about 15 hours (time required for the growth of ZnO nanowires having 3 µm of length);
To complete the realization of the piezoelectric layer, and to protect the obtained ZnO nanowires, a matrix made of dielectric material is deposited, for example polymethyl methacrylate (PMMA), preferably deposited by a Spin Coating technique.

In particular, the dielectric matrix has a thickness of about 3 µm, which is the minimum thickness necessary to cover the Zno nanowires.

A further layer of conductive material, for example of Aluminum, is then deposited, on the dielectric matrix comprising the ZnO nanofilaments, to form the second electrode of the device 100 (PZL-PMP).

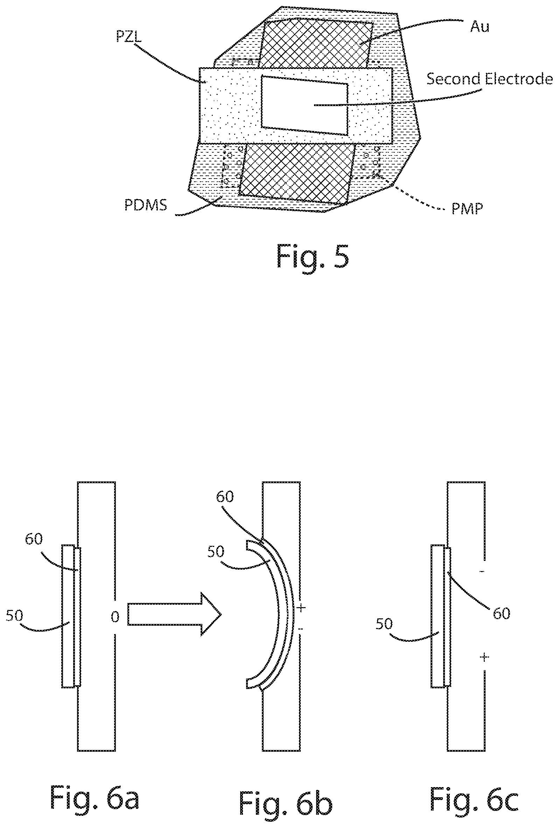

The preferred embodiment of the device 100 here described is schematized in Figure 4 and an image of a prototype realized is shown in Figure 5.

As shown in Figure 6, the device is configured to receive an incident light beam at the photopolymer layer.

The activable portion 30, which in particular has been described above as the "skeleton" of the photopolymer, is configured to move from a rest configuration shown in Figure 6a, to a bent configuration, at which a potential difference is provided at the terminal ends of the piezoelectric layer in Figure 6b, to a non-deflected configuration which provides a movement of the piezoelectric and therefore again a tension gradient at the terminal ends of the piezoelectric.

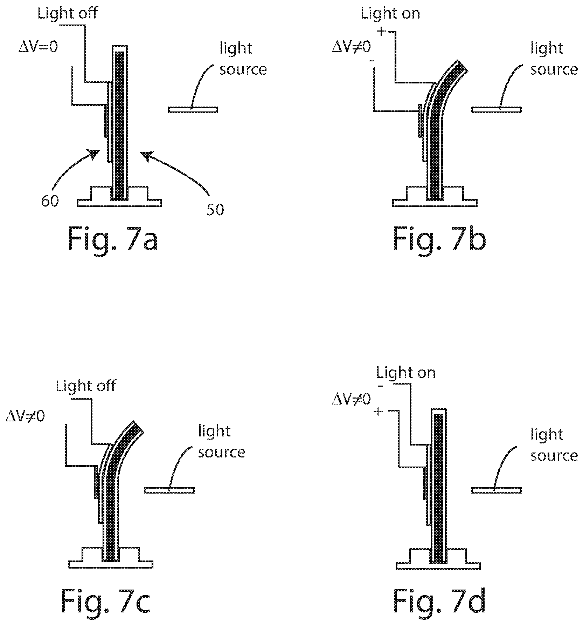

In order to optimize the movement of the activable semi-rigid elastic portion 30, it is provided to constrain an end of the device at at least one edge, as shown in Figures 7a-7d.

To uniform a voltage value detected in an operating condition, the energy conversion device 100 further comprises a rectifier element.

In particular, a diode rectifier, for example Graetz bridge-type, is provided to make continuous a voltage value detected at the ends of the piezoelectric and to make it independent of the type of movement of the flexible element and of the main movement direction of the flexible element ( bending and / or relaxation).

In general, the device according to the present invention, compared to a faster and more economical production method, has characteristics of higher efficiency, or at least comparable, with respect to the known devices, in terms of open circuit voltage (Voc) obtainable on parity of cm2 occupied surface.

In particular, the values obtainable with the embodiment of the device here described may reach a value of about 1 Voc/cm2. This value is comparable, for example, to the Voc value achieved with the latest generation triple-junction photovoltaic cells.

The device according to the present invention allows the possibility of obtaining "self-powered" energy from mechanical work induced by alternative sources, in particular light, and can be used both in the field of Energy Harvesting (EH) and in the advanced self-powered sensors field.

Advantageously, even in the absence of light energy, the device according to the present invention allows energy to be obtained from external agents such as wind and / or marine currents which cause movement of the flexible element.

Therefore, the object of the present invention can be understood to be in the frame of multifunction devices.

It is also possible to vary the parameters of the incident light in terms of intensity and wavelength.

The use of the device in the telecommunications field i salso provided, in particular in the field of opto-acoustics, for example by means of lab-on-chip integration, or for opto-electronic transducers, in opto-acoustic devices, in opto-fluidic devices.

The present invention has been described by way of illustration, but not of limitation, according to its preferred embodiments, but it is to be understood that variations and / or modifications may be made by those skilled in the art without departing from the scope of protection, as defined by the attached claims.

## Claims

1. Energy conversion device (100) configured to convert a light signal into an electrical signal, comprising:
- an actuator element (50), substantially planar, having at least one activatable portion (30);
- a transducer element (60), substantially planar, having at least a portion of piezoelectric material;
wherein said actuator element (50) is coupled to said transducer element (60),
said energy conversion device (100) being **characterized in that** said activatable portion (30) comprises a photomobile polymeric material so that, at a light beam incident on said photomobile polymeric material, a movement of said transducer element (60) is activated through a movement of said activable portion (30), said movement of said transducer element (60) providing the generation of a potential difference at the terminal ends of said portion of piezoelectric material.

2. Device (100) according to the preceding claim, wherein said activatable portion (30) is substantially elastic and is configured to be moved from a substantially planar configuration to a substantially bent operating configuration at an incident light beam.

3. Device (100) according to any one of the preceding claims, wherein said photomobile polymeric material comprises multi-acrylate components and phenol oxides in vinyl matrices.

4. Device (100) according to any one of the preceding claims, wherein said piezoelectric material comprises a portion made of metal oxide, optionally made of ZnO.

5. Device (100) according to the preceding claim, wherein said piezoelectric material comprises a nanostructured further portion, optionally comprising ZnO nanowires.

6. Device (100) according to any one of the preceding claims, comprising a first and a second electrode respectively positioned at the terminal ends of said portion of piezoelectric material.

7. Device (100) according to any one of claims 2 to 6, comprising a supporting element (10) configured to constrain at least said semi-rigid activable portion (30) and to allow said movement from a substantially planar configuration to a substantially bent operating configuration at an incident light beam, and vice versa.

8. Method of production of an energy conversion device configured to convert a light signal into an electrical signal, comprising the steps of:
- depositing a layer of photomobile polymeric material to obtain a substantially planar actuator element (50);
- depositing a layer of piezoelectric material to obtain a substantially planar transducer element (60);
wherein said transducer element (60) is coupled to said actuator element (50) so that, at a light beam incident on said photomobile polymeric material, a movement of said transducer element (60) is activated, providing the generation of a potential difference at the terminal ends of said piezoelectric material.

9. Method according to the preceding claim, wherein said photomobile polymeric material comprises multi-acrylate components, phenol oxides and vinyl matrices, optionally comprising a multi-acrylate, 4-amino-phenol and oxidized N-vinyl-pyrrolidone component.

10. Method according to the preceding claim, comprising an oxidation step of a surface portion of said photomobile polymeric material in an aerobic environment, for a time of about 96 hours, to obtain a semi-rigid activable portion (30).

11. Method according to the preceding claim, wherein before said step of depositing a piezoelectric material, a waterproofing step of said photopolymer is provided.

12. Method according to the preceding claim, wherein said step of depositing a piezoelectric material comprises the depositing of a ZnO layer and a subsequent growth step of ZnO nanowires.

13. Method according to the preceding claim, wherein before said step of depositing a layer of ZnO, a layer of conductive material is provided, said layer being configured to act as a first electrode.

14. Method according to one of the claims 12 or 13, comprising a step of depositing a dielectric matrix on said nanowires, optionally deposited by spin coating.

15. Method according to any one of the preceding claims, comprising a step of depositing a layer of conductive material on said piezoelectric material, said layer being configured to act as a second electrode.

## Patentansprüche

1. Energieumwandlungsvorrichtung (100), die so konfiguriert ist, dass sie ein Lichtsignal in ein elektrisches Signal umwandelt, umfassend:
- ein im Wesentlichen ebenes Betätigungselement (50), das mindestens einen aktivierbaren Abschnitt (30) aufweist;
- ein im Wesentlichen ebenes Wandlerelement (60), das mindestens einen Teil aus piezoelektrischem Material aufweist;
wobei das Betätigungselement (50) mit dem Wandlerelement (60) gekoppelt ist,
wobei die Energieumwandlungsvorrichtung (100) **dadurch gekennzeichnet ist, dass** der aktivierbare Abschnitt (30) ein photomobiles Polymermaterial umfasst, so dass bei einem auf das photomobile Polymermaterial einfallenden Lichtstrahl eine Bewegung des Wandlerelements (60) durch eine Bewegung des aktivierbaren Abschnitts (30) aktiviert wird, wobei die Bewegung des Wandlerelements (60) die Erzeugung einer Potentialdifferenz an den Anschlussenden des Abschnitts aus piezoelektrischem Material bereitstellt.

2. Vorrichtung (100) nach dem vorhergehenden Anspruch, wobei der aktivierbare Abschnitt (30) im Wesentlichen elastisch ist und so konfiguriert ist, dass er bei einem einfallenden Lichtstrahl von einer im Wesentlichen ebenen Konfiguration in eine im Wesentlichen gebogene Betriebskonfiguration bewegt wird.

3. Vorrichtung (100) nach einem der vorhergehenden Ansprüche, wobei das photomobile polymere Material Multi-Acrylatkomponenten und Phenoloxide in Vinylmatrizen umfasst.

4. Vorrichtung (100) nach einem der vorhergehenden Ansprüche, wobei das piezoelektrische Material einen Teil aus Metalloxid, gegebenenfalls aus ZnO, umfasst.

5. Vorrichtung (100) nach dem vorhergehenden Anspruch, wobei das piezoelektrische Material einen weiteren nanostrukturierten Teil umfasst, der optional ZnO-Nanodrähte umfasst.

6. Vorrichtung (100) nach einem der vorangehenden Ansprüche, die eine erste und eine zweite Elektrode umfasst, die jeweils an den Anschlussenden des Abschnitts aus piezoelektrischem Material angeordnet sind.

7. Vorrichtung (100) nach einem der Ansprüche 2 bis 6, umfassend ein Stützelement (10), das so konfiguriert ist, dass es zumindest den halbstarren aktivierbaren Abschnitt (30) einschränkt und die Bewegung von einer im Wesentlichen ebenen Konfiguration zu einer im Wesentlichen gebogenen Betriebskonfiguration bei einem einfallenden Lichtstrahl und umgekehrt ermöglicht.

8. Verfahren zur Herstellung einer Energieumwandlungsvorrichtung, die so konfiguriert ist, dass sie ein Lichtsignal in ein elektrisches Signal umwandelt, umfassend die folgenden Schritte:
- Aufbringen einer Schicht aus photomobilem Polymermaterial, um ein im Wesentlichen planares Betätigungselement (50) zu erhalten;
- Aufbringen einer Schicht aus piezoelektrischem Material, um ein im Wesentlichen planares Wandlerelement (60) zu erhalten;
wobei das Wandlerelement (60) mit dem Betätigungselement (50) gekoppelt ist, so dass bei einem auf das photomobile polymere Material auftreffenden Lichtstrahl eine Bewegung des Wandlerelements (60) aktiviert wird, was die Erzeugung einer Potentialdifferenz an den Anschlussenden des piezoelektrischen Materials bewirkt.

9. Verfahren nach dem vorhergehenden Anspruch, wobei das photomobile polymere Material Multi-AcrylatKomponenten, Phenoloxide und Vinylmatrizen umfasst, die gegebenenfalls eine Multi-Acrylat-, 4-Aminophenol-und oxidierte N-Vinylpyrrolidon-Komponente umfassen.

10. Verfahren nach dem vorhergehenden Anspruch, umfassend einen Oxidationsschritt eines Oberflächenabschnitts des photomobilen polymeren Materials in einer aeroben Umgebung für eine Zeit von etwa 96 Stunden, um einen halbstarren wirkungsfähigen Abschnitt (30) zu erhalten.

11. Verfahren nach dem vorhergehenden Anspruch, wobei vor dem Schritt des Auftragens eines piezoelektrischen Materials ein Schritt des Imprägnierens des Photopolymers vorgesehen ist.

12. Verfahren nach dem vorhergehenden Anspruch, wobei der Schritt des Abscheidens eines piezoelektrischen Materials das Abscheiden einer ZnO-Schicht und einen anschließenden Wachstumsschritt von ZnO-Nanodrähten umfasst.

13. Verfahren nach dem vorhergehenden Anspruch, wobei vor dem Schritt des Abscheidens einer ZnO-Schicht eine Schicht aus leitfähigem Material bereitgestellt wird, wobei die Schicht so konfiguriert ist, dass sie als eine erste Elektrode wirkt.

14. Verfahren nach einem der Ansprüche 12 oder 13, umfassend einen Schritt des Aufbringens einer dielektrischen Matrix auf die Nanodrähte, die gegebenenfalls durch Schleuderbeschichtung aufgebracht wird.

15. Verfahren nach einem der vorhergehenden Ansprüche, umfassend einen Schritt des Aufbringens einer Schicht aus leitfähigem Material auf das piezoelektrische Material, wobei die Schicht so konfiguriert ist, dass sie als zweite Elektrode wirkt.

## Revendications

1. Dispositif de conversion d'énergie (100) configuré pour convertir un signal lumineux en un signal électrique, comprenant:
- un élément d'actionnement (50), sensiblement plan, comportant au moins une partie activable (30);
- un élément transducteur (60), sensiblement plan, comportant au moins une partie de matériau piézoélectrique;
dans lequel l'élément actionneur (50) est couplé à l'élément transducteur (60),
ledit dispositif de conversion d'énergie (100) est **caractérisé en ce que** ladite partie activable (30) comprend un matériau polymère photomobile de sorte que, à un faisceau lumineux incident sur ledit matériau polymère photomobile, un mouvement dudit élément transducteur (60) est activé par un mouvement de ladite partie activable (30), ledit mouvement dudit élément transducteur (60) assurant la génération d'une différence de potentiel aux extrémités terminales de ladite partie de matériau piézoélectrique.

2. Dispositif (100) selon la revendication précédente, dans lequel ladite partie activable (30) est sensiblement élastique et est configurée pour passer d'une configuration sensiblement plane à une configuration de fonctionnement sensiblement courbée au niveau d'un faisceau lumineux incident.

3. Dispositif (100) selon l'une quelconque des revendications précédentes, dans lequel ledit matériau polymère photomobile comprend des composants multi-acrylates et des oxydes de phénol dans des matrices vinyliques.

4. Dispositif (100) selon l'une quelconque des revendications précédentes, dans lequel ledit matériau piézoélectrique comprend une partie en oxyde métallique, éventuellement en ZnO.

5. Dispositif (100) selon la revendication précédente, dans lequel ledit matériau piézoélectrique comprend une partie supplémentaire nanostructurée, comprenant éventuellement des nanofils de ZnO.

6. Dispositif (100) selon l'une quelconque des revendications précédentes, comprenant une première et une seconde électrode respectivement positionnée aux extrémités de ladite portion de matériau piézoélectrique.

7. Dispositif (100) selon l'une quelconque des revendications 2 à 6, comprenant un élément de support (10) configuré pour contraindre au moins ladite partie activable semi-rigide (30) et pour permettre ledit mouvement d'une configuration sensiblement plane à une configuration de fonctionnement sensiblement courbée au niveau d'un faisceau lumineux incident, et vice versa.

8. Procédé de fabrication d'un dispositif de conversion d'énergie configuré pour convertir un signal lumineux en un signal électrique, comprenant les étapes suivantes:
- dépôt d'une couche de matériau polymère photomobile pour obtenir un élément d'actionnement sensiblement planaire (50);
- dépôt d'une couche de matériau piézoélectrique pour obtenir un élément transducteur sensiblement plan (60);
dans lequel ledit élément transducteur (60) est couplé à l'élément actionneur (50) de sorte que, lors de l'incidence d'un faisceau lumineux sur le matériau polymère photomobile, un mouvement de l'élément transducteur (60) est activé, ce qui génère une différence de potentiel aux extrémités du matériau piézoélectrique.

9. Procédé selon la revendication précédente, dans lequel ledit matériau polymère photomobile comprend des composants multi-acrylates, des oxydes de phénol et des matrices vinyliques, comprenant éventuellement un composant multi-acrylate, 4-amino-phénol et N-vinyl-pyrrolidone oxydée.

10. Procédé selon la revendication précédente, comprenant une étape d'oxydation d'une partie superficielle dudit matériau polymère photomobile en milieu aérobie, pendant une durée d'environ 96 heures, pour obtenir une partie activable semi-rigide (30).

11. Procédé selon la revendication précédente, dans lequel avant ladite étape de dépôt d'un matériau piézoélectrique, une étape d'imperméabilisation dudit photopolymère est prévue.

12. Procédé selon la revendication précédente, dans lequel l'étape de dépôt d'un matériau piézoélectrique comprend le dépôt d'une couche de ZnO et une étape ultérieure de croissance de nanofils de ZnO.

13. Procédé selon la revendication précédente, dans lequel avant ladite étape de dépôt d'une couche de ZnO, une couche de matériau conducteur est fournie, ladite couche étant configurée pour agir comme une première électrode.

14. Procédé selon l'une des revendications 12 ou 13, comprenant une étape de dépôt d'une matrice diélectrique sur lesdits nanofils, éventuellement déposée par spin coating.

15. Procédé selon l'une quelconque des revendications précédentes, comprenant une étape de dépôt d'une couche de matériau conducteur sur ledit matériau piézoélectrique, ladite couche étant configurée pour agir comme une seconde électrode.
